# EUROPÄISCHE PATENTSCHRIFT

(11) **EP 2 092 570 B1**
(45) Veröffentlichungstag und Bekanntmachung des Hinweises auf die Patenterteilung: **23.01.2019**
(21) Anmeldenummer: 07815199.0
(22) Anmeldetag: 05.12.2007
(51) Int. Cl.: H01L 31/0224

(54) **SCHICHTAUFBAU**
LAYERED STRUCTURE
STRUCTURE MULTICOUCHE

(30) Priorität: 05.12.2006 AT 20182006
(43) Veröffentlichungstag der Anmeldung: 26.08.2009
(73) Patentinhaber: ASMAG-Holding GmbH, 4645 Grünau im Almtal (AT)
(72) Erfinder: PADINGER, Franz, 4502 St. Marien (AT); SCHRÖTER, Klaus, 10707 Berlin (DE)
(74) Vertreter: Ofner, Clemens
(86) Internationale Anmeldenummer: PCT/AT2007/000548
(87) Internationale Veröffentlichungsnummer: WO 2008/067577

(56) Entgegenhaltungen:
- EP-A- 1 715 529
- WO-A-99/38217
- DE-A1- 3 814 615
- DE-A1-102004 050 269

## Beschreibung

Die Erfindung betrifft einen Schichtaufbau mit halbleitenden Materialien auf einer Trägerlage, welcher zumindest eine flächenhafte, halbleitende Schicht und mehrere, insbesondere eine erste und zweite, Elektroden umfasst, wobei die halbleitende Schicht eine obere und untere Flachseite aufweist, die im Wesentlichen parallel zueinander verlaufen und durch die Höhe der Schicht voneinander distanziert sind und wo die halbleitende Schicht mit der unteren Flachseite auf einer Flachseite der Trägerlage aufgebracht ist und wobei die beiden Elektroden elektrisch leitend mit der halbleitenden Schicht verbunden sind, sowie ein Verfahren zur Herstellung desselben. Ein solcher Schichtaufbau ist in dem Dokument EP 1715529 A2 offenbart. Weiters betrifft die Erfindung eine Solarzelle zur Freisetzung von Ladungsträger durch das Einwirken einer elektromagnetischen Welle, insbesondere Licht, sowie einen Transistor.

Die Ableitung freigesetzter Ladungsträger aus einer flächenhaften halbleitenden Schicht erfolgt bevorzugt mittels, auf den Flachseiten der Schicht angebrachten, elektrisch leitenden Elektroden.

Halbleitende Bauteile sind üblicherweise schichtartig aufgebaut, wobei die flächenhaften halbleitenden Schichten bevorzugt übereinander angeordnet sind. Die Ableitung der Elektronen aus den halbleitenden Schichten eines derartigen Schichtaufbaus erfolgt über elektrisch leitende Elektroden, die bevorzugt zwischen den Schichten angeordnet sind. Gegebenenfalls sind zusätzliche Zwischenschichten erforderlich, beispielsweise elektrisch isolierende Schichten. Für eine möglichst gute Ableitung der Ladungsträger aus dem halbleitenden Material sollten diese Elektroden aus einem elektrisch sehr gut leitfähigen Material bestehen.

Ist die halbleitende Schicht beispielsweise aus einem photoaktiven Material gebildet, sind Vorkehrungen zu treffen, damit die Elektroden den Strahlengang des einfallenden Lichts nicht zu stark beeinträchtigen. Die Elektroden, insbesondere jedoch die der Lichtquelle zugewandte, müssen daher zumindest im dem Teil des Spektrums des einfallenden Lichts transparent bzw. semitransparent sein, in dem die halbleitende Schicht photoaktiv ist. Nachteilig ist dabei, dass transparente bzw. semitransparente Elektroden bevorzugt aus einem Metall-Oxid bestehen, das aber gegenüber einem metallischen Leiter eine deutlich schlechtere elektrische Leitfähigkeit aufweist. Bei einem Schichtaufbau mit mehreren halbleitenden Schichten sind somit mehrere transparente bzw. semitransparente Elektroden im Strahlengang des einfallenden Lichts hintereinander angeordnet. Da jede dieser Elektroden einen Teil des einfallenden Lichts absorbiert, ist die Anzahl der derart übereinander angeordneten Schichten begrenzt, da das Licht nach dem Durchtritt durch mehrere Elektroden so stark abgeschwächt ist, dass die Energie zur Freisetzung von Ladungsträgern in der photoaktiven Schicht nicht mehr ausreicht. Die Aufgabe der Erfindung ist es, Ladungsträger, die in zumindest einer halbleitenden Schicht durch eine einwirkende Beeinflussung freigesetzt wurden, über elektrisch sehr gut leitende Elektroden aus der Schicht abzuleiten, wobei sich keine Elektroden in der Wirkrichtung der Ladungsträger freisetzenden Beeinflussung befinden dürfen.

Die Aufgabe der Erfindung wird jeweils eigenständig durch den Sachverhalt des unabhängigen Anspruchs 1 dadurch gelöst, dass
- die zumindest zwei Elektroden an zwei gegenüber liegenden Stirnflächen der halbleitenden Schicht und/oder an dazu zumindest annähernd parallelen Ebenen zwischen den beiden Stirnflächen angeordnet und auf die Trägerlage aufgedruckt sind;
- die Solarzelle bzw. der Transistor einen erfindungsgemäßen Schichtaufbau aufweisen. Da die zumindest zwei Elektroden an zwei gegenüber liegenden Stirnflächen der halbleitenden Schicht und/oder an dazu zumindest annähernd parallelen Ebenen zwischen den beiden Stirnflächen angeordnet sind, ist sicher gestellt, dass sich keine Elektrode in der Wirkrichtung einer Ladungsträger freisetzenden Beeinflussung, beispielsweise einer elektromagnetischen Welle, befindet. Der besondere Vorteil des anspruchsgemäßen Schichtaufbaus ist, dass die gesamte Flachseite der halbleitenden Schicht als Wirkfläche zur Verfügung steht.

Sind die Trägerlage, die halbleitende Schicht und die Elektroden flexibel und elastisch rückstellbar verformbar ausgebildet, lässt sich der erfindungsgemäße Schichtaufbau besonders vorteilhaft auch an nicht ebenen Auflageflächen anbringen. Insbesondere ist dadurch auch eine Verwendung in Vorrichtungen denkbar, bei denen es zu starken Erschütterungen bzw. zu einer dynamischen Verformung der Auflagefläche kommen kann. Beispielsweise lässt sich der Schichtaufbau daher auch auf Geräten anbringen die für einen mobilen Einsatz vorgesehen sind, wo mit Schlägen, Erschütterungen und mechanischen Verformungen durchaus zu rechnen ist. In einer vorteilhaften Weiterbildung lässt sich der anspruchsgemäße Schichtaufbau beispielsweise auch auf Textilien anbringen.

Bei einer transparent ausgebildeten Trägerlage ist das Einwirken einer Ladungsträger freisetzenden Beeinflussung auch aus Richtung der unteren Flachseite der halbleitenden Schicht möglich. Der bedeutende Vorteil ist dabei, dass der anspruchsgemäße Schichtaufbau dadurch zwei Vorzugsrichtungen für das Einwirken einer Ladungsträger freisetzenden Beeinflussung hat. Dies ist insbesondere von Vorteil, wenn aus Montagegründen der Schichtaufbau mit der Trägerlage in Richtung der Ladungsträger freisetzenden Beeinflussung angeordnet wird und somit die halbleitenden Schichten von der Wirkrichtung der Beeinflussung abgewandt wären.

Ist die Trägerlage aus einem elektrisch nicht leitenden Material gebildet, ist es möglich, die Elektroden bzw. die halbleitende Schicht unmittelbar auf der Trägerlage anzubringen. Von Vorteil ist dabei, dass keine zusätzliche Trennschicht, insbesondere keine Isolierschicht, erforderlich ist.

Wird das halbleitende Material aus einer Gruppe umfassend photoaktive Materialien, organische und anorganische halbleitende Materialien gebildet, ist es mit dem anspruchsgemäß ausgebildeten Schichtaufbau möglich, eine Freisetzung von Ladungsträgern durch eine Vielzahl von einwirkenden Beeinflussungen zu erreichen. Beispielsweise ermöglicht eine Ausbildung mit photoaktivem Materials den Aufbau einer Solarzelle - die einwirkende Beeinflussung wäre in diesem Fall ein Teilbereich des Sonnenlichts. Denkbar ist aber auch, dass die halbleitende Schicht für hochfrequente Elektromagnetische Wellen aktiv ist und daher beim Eintreffen einer Welle mit der entsprechenden Frequenz, Ladungsträger freigesetzt werden. Ebenfalls möglich sind Kombinationen aus organischen und anorganischen Materialien, wobei die Palette der verwendbaren Materialien sehr breit ist und beispielsweise Polymere, Small Molecules, Dendrimers, Quantum Dots, anorganische Nanopartikel und auch Carbon Nanotubes umfasst. Eine photoaktive Schicht kann aus einer einzelnen Komponente bestehen, oder aber auch aus zumindest zwei Komponenten (Donator, Akzeptor) aufgebaut sein. Durch Mischen des Polymers mit akzeptorartigen Materialien, beispielsweise anorganische Nanopartikeln, lässt sich eine effizientere Ladungstrennung realisieren, weil dadurch die Grenzfläche zwischen den beiden Komponenten über das gesamte Absorbervolumen verteilt ist - man spricht hier von einer bulk-heterojunction.

Wird auf der halbleitenden Schicht, zumindest eine weitere, bevorzugt aus einem anderen halbleitenden Material gebildete Schicht aufgebracht, lassen sich komplexe halbleitende Bauteile aufbauen. Eine anspruchsgemäße Ausbildung mit organischem bzw. anorganischem Material gestattet beispielsweise den Aufbau von Sensoren oder Transistoren. Halbleitende Bauteile wie Transistoren umfassen üblicherweise mehrere Schichten aus unterschiedlichen halbleitenden Materialien, die übereinander angebracht sind und die sich zumindest abschnittsweise überlappen. An den Übergängen zwischen den Schichten ergeben sich nun genau jene Effekte, die bspw. das Verhalten eines Transistors ausmachen. Der schichtartige Aufbau erlaubt es weiters, die Eigenschaften der einzelnen Schichten derart vorteilhaft zu kombinieren, dass man ein Bauteil erhält, das für einen breiteren Bereich bzw. für mehrere mögliche einwirkende Beeinflussungen optimiert ist. Beispielsweise können die Schichten dahingehend optimiert werden, dass jede Schicht in einem Teilbereich des Sonnenlichts einen besonders hohen Absorptionsgrad aufweist. Man erhält dann eine Solarzelle, die in einem breiten Spektralbereich des Sonnenlichts einen hohen Absorptionsgrad und damit einen hohen Wirkungsgrad aufweist.

Ist das photoaktive Material anspruchsgemäß zur Absorption eines Teilbereichs des Spektrums des Lichts, insbesondere des Sonnenlichts, ausgebildet, werden bei Sonneneinstrahlung innerhalb der Schicht Ladungsträger freigesetzt. Ein photoaktives Material lässt sich nun dahingehend optimieren, dass es in einem Teilbereich eine besonders hohe Absorptionsrate aufweist und daher besonders viele Ladungsträger freisetzt. Viele freigesetzte Ladungsträger bedeuten wiederum ein hohes Stromabgabevermögen und somit einen höheren Wirkungsgrad. Insbesondere ist es technisch einfacher, die Absorptionsrate einer photoaktiven, halbleitenden Schicht für einen schmalen Spektralbereich zu optimieren, als eine hohe Absorptionsrate über einen breiten Spektralbereich erreichen zu wollen.

Ist das photoaktive Material für den nicht absorbierten Teilbereich des Spektrums des Lichts, insbesondere des Sonnenlichts transparent, können jene spektralen Anteile für die die halbleitende Schicht nicht photoaktiv ist, die Schicht weitestgehend ungehindert passieren. Der bedeutende Vorteil ist dabei, dass die Energie der nicht photoaktiv genutzten Spektralanteile weitestgehend erhalten bleibt.

Dadurch dass jede aufgebrachte photoaktive Schicht einen anderen Teilbereich Spektrums des Lichts, insbesondere des Sonnenlichts absorbiert, ist eine vorteilhafte Ausnutzung mehrerer Spektralbereiche des Lichts möglich. Ordnet man einzelne photoaktive Schichten die für eine hohe Absorption in einem Teilbereich des Lichts optimiert wurden, anspruchsgemäß übereinander an, erfolgt beim Durchtritt des Lichts durch die zu oberst liegende photoaktive Schichte, eine Absorption eines Teilbereichs des Spektrums des Lichts, wobei die nicht absorbierten Teile des Spektrums weitestgehend unbeeinflusst durchgelassen werden. Die zumindest eine weitere aufgebrachte Schicht nützt hernach einen überwiegend andern Spektralbereich zur Energiegewinnung, wobei sich allerdings die photoaktiven Spektralbereiche der Schichten teilweise überlappen können. Insgesamt erhält man den entscheidenden Vorteil, dass sich mit dem anspruchsgemäßen Schichtaufbau eine deutliche Steigerung des Wirkungsgrads erreichen lässt. Im Gegensatz zu den bisher bekannten Schichtaufbauten ermöglicht der anspruchsgemäße Schichtaufbau deutlich mehr halbleitende Schichten übereinander anzuordnen, da keine transparenten bzw. semitransparenten Elektroden zwischen den halbleitenden Schichten erforderlich sind. Der wesentliche Vorteil ist dabei, dass, bezogen auf eine Flächeneinheit der Trägerlage, die Zahl der freigesetzten Ladungsträger und somit der abgegebene Strom, deutlich höher als bei den bisher bekannten Schichtaufbauten ist.

Sind die Elektroden vollflächig an den Seitenflächen der halbleitenden Schicht elektrisch leitend verbunden angebracht, ist eine bestmögliche Ladungsträgerableitung gegeben, da bei dieser Ausbildung der elektrische Übergangswiderstand zwischen halbleitender Schicht und Elektrode am geringsten ist. Neben einer vollflächig angebrachten Elektrode, sind aber auch noch weitere Elektrodenausbildungen möglich. Beispielsweise können die Elektroden gitter- bzw. streifenartig und/oder nur in diskreten Abschnitten aufgebracht sein. Ebenfalls denkbar ist eine Ausbildung als poröse Elektrode, bspw. als Sinterelektrode.

In halbleitenden Materialien kommt es durch Rekombination zur gegenseitigen Auslöschung von freigesetzten Ladungsträgern. Dieser Effekt tritt umso stärker in Erscheinung, je weiter die Elektroden voneinander entfernt sind, d.h. je dicker die halbleitende Schicht zwischen den Elektroden ist, bzw. je schlechter die freigesetzten Elektronen aus der halbleitenden Schicht abgezogen werden. Dadurch dass die erste bzw. zweite Elektrode aus jeweils einem unterschiedlichen Metall mit einer unterschiedlichen Elektronenaustrittsarbeit (work function) gebildet ist, lässt sich die interne Quanteneffizienz der jeweiligen Schicht erhöhen, weil dadurch weniger freigesetzte Ladungsträger durch Rekombination verloren gehen. In vorteilhafter Weise erreicht man mit der anspruchsgemäßen Ausbildung wiederum eine Steigerung des Wirkungsgrads des gesamten Bauteils.

Werden jeweils alle ersten und zweiten Elektroden elektrisch leitend miteinander verbunden, erhält man eine elektrische Parallelschaltung aller auf der Trägerlage angeordneten Schichtaufbauten. Der entscheidende Vorteil einer anspruchsgemäßen Ausbildung liegt darin, dass auf der Trägerlage kein Platz für den elektrisch leitenden Anschluss der einzelnen Elektroden verloren geht, wodurch wesentlich mehr halbleitende Fläche zur Freisetzung von Ladungsträgern vorhanden ist, was wiederum den Wirkungsgrad erhöht.

Werden die Elektroden als ineinander verschränkte Fingerelektroden ausgebildet, wird eine besonders vorteilhafte Platz sparende Anordnung der Elektroden und der halbleitenden Schicht erreicht. Eine anspruchsgemäße Ausbildung hat den weiteren Vorteil, dass sich die Elektroden derart anordnen lassen, dass parallel zur Flachseite der Trägerlage, eine gleichmäßig breite Schicht des halbleitenden Materials angebracht ist. Dadurch lassen sich lokale Konzentrationen von freigesetzten Ladungsträgern weitestgehend vermeiden und es kommt zu keiner ungleichmäßigen Strombelastung der Elektroden.

Die erfindungsgemäße Aufgabe wird auch durch ein Verfahren zum Herstellen eines Schichtaufbaus mit halbleitenden Materialien auf einer Trägerlage gemäß dem Anspruch 14 gelöst, wobei die zumindest zwei Elektroden an zwei gegenüber liegenden Stirnflächen der halbleitenden Schicht und/oder an dazu zumindest annähernd parallelen Ebenen zwischen den beiden Stirnflächen angeordnet werden, wobei die zumindest zwei Elektroden auf die Trägerlage aufgedruckt werden.

Der erfindungsgemäße Schichtaufbau nützt einen halbleitenden Effekt der sich einstellt, wenn eine halbleitende Schicht zwischen zwei unterschiedlichen metallischen Werkstoffen angeordnet ist. Werden anspruchsgemäß abwechselnd und voneinander distanziert, erste und zweite Elektroden aufgebracht, lässt sich der erfindungsgemäße Schichtaufbau besonders Platz sparend auf der Trägerlage anbringen. Von bedeutendem Vorteil ist weiters, dass zum Aufbringen der Elektroden Verfahren eingesetzt werden können, die beispielsweise eine vorhandene halbleitende Schicht beschädigen würden.

Dadurch dass die Elektroden mittels eines Strukturierungsverfahren, beispielsweise Lithografie, Siebdruck, Ink-Jet, Nanoimprint, Stempeldruck, Laser Ablation (hier ist eine vorhergehende Flächenbeschichtung, beispielsweise eine Bedampfung, erforderlich) auf die Trägerlage aufgebracht werden, ist eine kostengünstige Herstellung der Elektroden möglich.

Die genannten Verfahren haben weiters den Vorteil, dass sie keine aufwändigen und damit teuren Vorrichtungen, wie bspw. eine Hochvakuumkammer, erfordern. Weiters sind diese Verfahren dazu geeignet, die erfindungsgemäße Schichtvorrichtung kontinuierlich herzustellen.

Eine Aufbringung der beiden Elektroden als verschränkte Fingerelektroden bringt mehrere bedeutende Vorteile. Durch die Verschränkung der Elektroden wird der Platz auf der Trägerlage besonders optimal ausgenutzt, da kein Platz für elektrisch leitende Verbindungsleitungen zwischen den Elektroden, bzw. für Isolationsmaßahmen der Elektroden gegeneinander verloren geht. Weiters lassen sich die Fingerelektroden derart vorteilhaft ausgestalten, dass, parallel zur Trägerlage, die Breite der halbleitenden Schicht zwischen den beiden Elektroden weitestgehend konstant ist und es daher zu keinen lokal erhöhten Ladungsträgerdichten kommt. Aufgrund der Rekombinationseffekte soll die Breite der Schicht zwischen den Elektroden möglichst gering sein, daher sind als Weiterbildung alle Elektrodenanordnungen denkbar, die einen möglichst guten Abtransport der freigesetzten Ladungsträger ermöglichen.

Von wesentlichem Vorteil einer anspruchsgemäßen Ausbildung, bei der die halbleitende Schicht vollflächig aufgebracht wird ist, dass die halbleitende Schicht sowohl auf der Trägerlage als auch auf den zuvor aufgebrachten Elektroden aufgebracht wird. Da die Elektroden bereits zuvor auf der Trägerlage angebracht wurden, lagert sich auch auf deren oberen Flachseite das halbleitende Material ab, was aber den Abtransport der freigesetzten Ladungsträger nicht beeinträchtigt. Daher ist es vorteilhafter Weise nicht erforderlich, die halbleitende Schicht von den Elektroden zu entfernen bzw. beim Auftragen der halbleitenden Schicht zu verhindern, dass sich diese auf den Elektroden anlagert. Es können daher Flächendruckverfahren wie beispielsweise Rakel, Siebdruck, Gravurdruck, Tiefdruck, Flexodruck, Dip-Coating und Spray-Coating eingesetzt werden.

Der Einsatz eines Verfahrens aus der Gruppe umfassend Bedampfung, Flächendruckverfahren (beispielsweise Rakel, Siebdruck, Gravurdruck, Tiefdruck, Flexodruck, Dip-Coating, Spray-Coating), zum Auftragen der halbleitenden Schicht, hat den Vorteil, dass diese Verfahren eine einfache und kostengünstige Herstellung des Schichtaufbaus ermöglichen. Insbesondere haben die genannten Verfahren den Vorteil, dass sie keine aufwändigen und damit teuren Vorrichtungen, wie bspw. eine Hochvakuumkammer, erfordern. Weiters sind diese Verfahren dazu geeignet, die erfindungsgemäße Schichtvorrichtung kontinuierlich herzustellen.

Ein strukturiertes Aufbringen der halbleitenden Schicht hat den Vorteil, dass sich dadurch gezielt Strukturen ausbilden lassen, um bspw. den Wirkungsgrad oder die Ladungsträgerbeweglichkeit zu erhöhen. Insbesondere ist es anspruchsgemäß möglich, gezielt in Abschnitten keine halbleitende Schicht aufzutragen, um Platz bspw. für einen elektrischen Anschluss frei zu lassen. Weiters lassen sich dadurch auch normal zur Ebene der Trägerlage stehende, halbleitende Strukturen aufbauen.

Die Verwendung eines Verfahren aus der Gruppe umfassend Tintenstrahl-Druck, Siebdruck, Laser Ablation hat ebenso den Vorteil, dass keine aufwändigen und damit teuren Vorrichtungen erforderlich sind und das eine kontinuierliche Herstellung der erfindungsgemäßen Schichtvorrichtung im Durchlaufverfahren möglich ist.

Wird während des Aufbringens der halbleitenden Schicht ein Elektrisches Feld angelegt, lässt sich die Ausrichtung der Moleküle in der halbleitenden Schicht beeinflussen. Der bedeutende Vorteil dieser Ausbildung ist, dass sich dadurch die Leitfähigkeit der halbleitenden Schicht erhöhen lässt. Dies ist insbesondere von Bedeutung, als dass sich die bereits erwähnten Rekombinationseffekte durch eine höhere Leitfähigkeit der halbleitenden Schicht reduzieren lassen. Eine Feldstärke von 10⁻⁵V/cm entspricht 1V/100nm Schichtdicke.

Durch eine geeignete Materialkombination lässt sich eine höhere Quanteneffizienz der halbleitenden Schicht erzielen, was den bedeutenden Vorteil hat, dass bereits bei einer geringeren Intensität der einwirkenden Beeinflussung Ladungsträger freigesetzt werden. Dadurch erhöht sich wiederum der Wirkungsgrad des erfindungsgemäßen Schichtaufbaus.

Wird auf der oberen Flachseite der halbleitende Schicht zumindest eine weitere, bevorzugt aus einem anderen halbleitenden Material gebildete Schicht aufgebracht, lässt sich ein besonders Platz sparender Schichtaufbau ausbilden. Halbleitende Schichten lassen sich für verschiedene Einsatzzwecke optimieren. Sind die halbleitenden Schichten beispielsweise photoaktiv ausgebildet und ist jede Schicht für einen spezifischen Spektralbereich des einfallenden Lichts optimiert, lässt sich anspruchsgemäße eine Solarzelle aufbauen, die deutlich mehr Spektralanteile zur Energiegewinnung nutzt, als gegenwärtig bekannte Solarzellen. Durch die anspruchsgemäße Anordnung erhält man den besonderen Vorteil, dass sich durch Anordnen einer weiteren halbleitenden Schicht, die Zahl der je Flächeneinheit der Trägerlage freigesetzten Ladungsträger erhöhen lässt.

Bei der Mehrzahl der bisher bekannten Solarzellen erfolgt die Ableitung der freigesetzten Ladungsträger aus den halbleitenden Schichten dadurch, dass zwischen den halbleitenden Schichten jeweils eine transparente bzw. semitransparente Elektrode angebracht ist. Wie bereits beschrieben, weisen transparente bzw. semitransparente Elektroden im Gegensatz zu metallischen Materialien, eine deutlich geringere Leitfähigkeit auf. Eine anspruchsgemäß ausgebildete Solarzelle hat jedoch keine Elektroden im Strahlengang des einfallenden Lichts. Daher lassen sich auch mehrere photoaktive Schichten übereinander anordnen was einerseits den Wirkungsgrad erhöht und andererseits eine bessere Platzausnutzung der Fläche der Trägerlage bringt. Der bedeutende Vorteil einer anspruchsgemäß ausgebildeten Solarzelle liegt daher in einer deutlich erhöhten Energiedichte.

Auch Transistoren weisen meist einen schichtartigen Aufbau auf, wobei auch hier das Problem besteht, freigesetzte Ladungsträger aus den halbleitenden Schichten abzutransportieren. Auch für derartige Bauteile lässt sich der erfindungsgemäße Schichtaufbau besonders vorteilhaft einsetzen. Durch die Anordnung der Elektroden an den Stirnseiten der halbleitenden Schichten lassen sich die Bauteile kompakter und damit wirtschaftlicher herstellen.

Die Erfindung wird im Nachfolgenden anhand der in den Zeichnungen dargestellten Ausführungsbeispiele näher erläutert.

Es zeigen jeweils in schematisch vereinfachter Darstellung:
- Fig. 1: einen Schichtaufbau in perspektivischer Ansicht;
- Fig. 2: einen Schichtaufbau mit mehreren Schichten;
- Fig. 3: einen Schichtaufbau mit Fingerelektroden in Draufsicht;
- Fig. 4: einen nicht maßstäblichen Schnitt durch den Schichtaufbau aus Fig. 3.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind bei einer Lageänderung sinngemäß auf die neue Lage zu übertragen. Weiters können auch Einzelmerkmale oder Merkmalskombinationen aus den gezeigten und beschriebenen unterschiedlichen Ausführungsbeispielen für sich eigenständige, erfinderische oder erfindungsgemäße Lösungen darstellen.

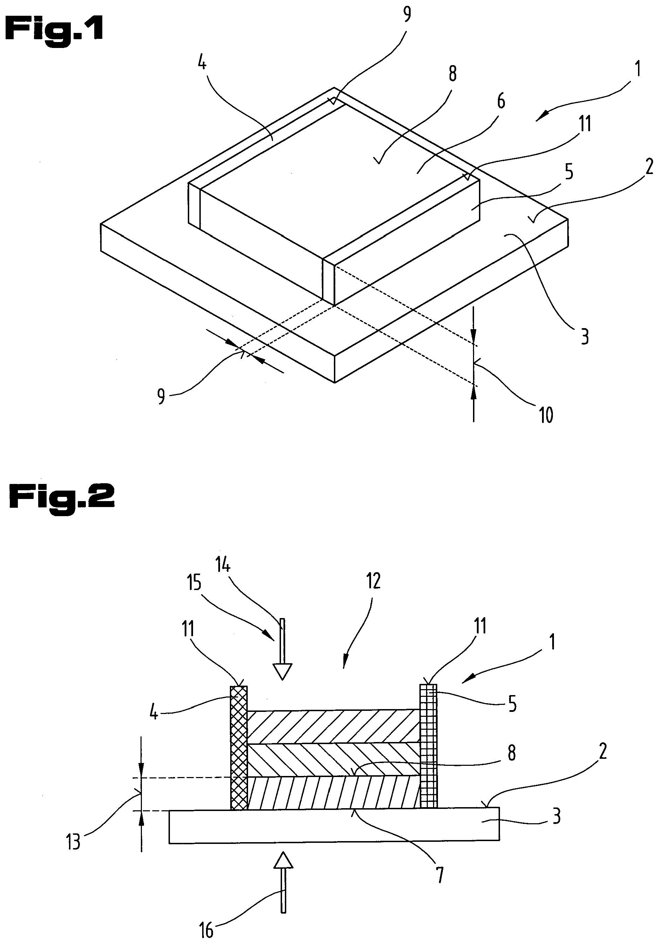

Fig. 1 zeigt einen Schichtaufbau 1 der auf einer Flachseite 2 der Trägerlage 3 aufgebracht ist und eine erste 4 und zweite 5 Elektrode umfasst. Zwischen den beiden Elektroden ist eine halbleitende Schicht 6 angeordnet, die eine untere 7 und obere 8 Flachseite aufweist. Die Trägerlage 3 des abgebildeten erfindungsgemäßen Schichtaufbaus 1 ist beispielsweise aus einem elektrisch nicht leitenden Kunststoff gebildet. In einer vorteilhaften Weiterbildung kann dieser Kunststoff beispielsweise transparent und/oder flexibel und elastisch verformbar ausgebildet sein. Ebenso möglich ist eine folienartige Ausbildung. Der erfindungsgemäße Schichtaufbau 1 ist jedoch nicht auf Kunststoffe als Trägerlage festgelegt, sondern es lassen im Wesentlichen alle weitestgehend ebenen Trägerlagen verwenden.

Auf die Flachseite 2 der Trägerlage werden mittels eines Strukturierungsverfahren, beispielsweise Lithographie, Siebdruck, usw., eine erste 4 und zweite 5 elektrisch leitende Elektrode aufgebracht. Der wesentliche Vorteil des erfindungsgemäßen Schichtaufbaus ist, dass die Elektroden aus elektrisch sehr gut leitenden metallischen Werkstoffen gebildet sind. Beispielsweise kann die erste Elektrode aus Aluminium (Al) und die zweite Elektrode aus Kupfer (Cu) oder Gold (Au) gebildet sein. Die Elektroden weisen eine geringe Grundfläche auf, insbesondere ist der Quotient aus Dicke 9 und Höhe 10 der Elektroden kleiner als 1. Nachdem die Elektroden aufgebracht wurden, wird vollflächig über die Trägerlage und über die Elektroden, mittels eines Verfahrens aus der Gruppe umfassend Bedampfung, Flächendruck (beispielsweise Rakel, Siebdruck, Gravurdruck, Tiefdruck, Flexodruck, Dip-Coating, Spray-Coating), die halbleitende Schicht 6 aufgebracht. Für die Funktion des Schichtaufbaus ist es unerheblich, dass sich die halbleitende Schicht auch auf der oberen Flachseite 11 der Elektroden anlagert. Ist die Trägerlage beispielsweise aus einem elektrisch leitenden Material gebildet, muss vor dem Aufbringen der Elektroden und der halbleitenden Schicht, eine elektrisch isolierende Zwischenschicht auf der Flachseite 2 der Trägerlage aufgebracht werden, um einen Kurzschluss der Elektroden zu verhindern. Eine vorteilhafte Weiterbildung einer elektrisch leitenden Trägerlage könnte darin bestehen, dass die Schutzschicht strukturiert aufgebracht wird, wobei beispielsweise der Abschnitt freigelassen wird, wo hernach die erste Elektrode aufgebracht wird. Werden hernach die erste und zweite Elektrode aufgebracht, ist die erste Elektrode unmittelbar mit der elektrisch leitenden Trägerlage verbunden und die Stromweiterleitung erfolgt direkt über die elektrisch leitende Trägerlage.

Bei dem in Fig. 2 dargestellten Schichtaufbau 1, ist eine erste 4 und zweite 5 Elektrode unmittelbar auf der Trägerlage 3 aufgebracht. Zwischen den beiden Elektroden sind insgesamt drei halbleitende Schichten 12 übereinander angeordnet, wobei jede Schicht eine untere 7 und eine obere 8 Flachseite, sowie eine Dicke 13 aufweist. Die einzelnen Schichten sind beispielsweise aus Polymeren, Carbon Nanotubes, Small Molecules, Dendrimers, Quantum Dots, anorganische Nanopartikel, sowie Mischungen von diesen gebildet und werden in mehreren Arbeitsschritten nacheinander aufgebracht, wobei dies besonders vorteilhaft beispielsweise in einem Durchlauf- bzw. einem Druckverfahren erfolgen kann. Da die Elektroden seitlich an den halbleitenden Schichten angebracht sind, kann die einwirkende Beeinflussung 14 ungehindert alle übereinander angeordneten Schichten erreichen. Ist die Trägerlage vorteilhaft transparent ausgebildet, kann neben einer oberen 15 einwirkenden Beeinflussung, auch eine Ladungsträger freisetzende Beeinflussung von der Unterseite 16 der Trägerlage einwirken.

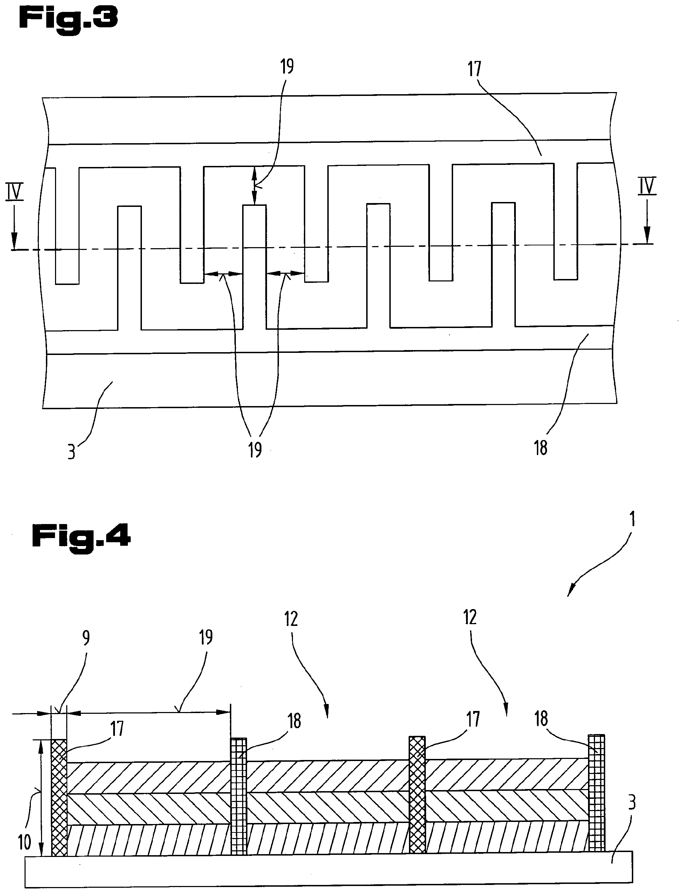

Fig. 3 zeigt einen Schichtaufbau 1, wobei die Elektroden als ineinander verschränkte, erste 17 und zweite 18 Fingerelektroden ausgebildet sind und durch den Abstand 19 voneinander distanziert sind. Durch diese Anordnung lässt sich eine kontinuierliche Breite 19 der halbleitenden Schicht zwischen der ersten und zweiten Fingerelektrode erreichen. In vorteilhafter Weiterbildung sind aber auch andere Elektrodenformen denkbar, bei denen eine gute Ableitung der freigesetzten Ladungsträger aus der zumindest einen halbleitenden Schicht sicher gestellt ist. Beispielsweise können sternförmig oder ineinander verzahnte Dreieckselektroden eingesetzt werden. Durch die ineinander verschränkte Anordnung der Elektroden wird eine möglichst optimale Ausnutzung des auf der Trägerlage zur Verfügung stehenden Platzes erreicht.

Fig4. zeigt den nicht maßstabsgetreuen Schnitt aus Fig. 3. Die ersten 17 und zweiten 18 Fingerelektroden sind abwechselnd und durch die Schicht 19 voneinander distanziert auf der Trägerlage angeordnet, wobei jede Elektrode eine Höhe 10 und eine Dicke 9 aufweist. Auf die Trägerlage und auf die zuvor aufgebrachten Elektroden wird hernach schichtweise 12 jeweils eine halbleitende Schicht aufgebracht.

Der erfindungsgemäße Schichtaufbau lässt sich beispielsweise auch auf Textilien anbringen. Eine anspruchsgemäß ausgebildete Solarzelle dient als Energiequelle, die Funktionslogik wird durch eine Baugruppe realisiert, die aus anspruchsgemäß ausgebildeten Transistoren gebildet ist. Denkbar ist beispielsweise eine Sportbekleidung, die während des Trainings physiologische Parameter überwacht und bei Erreichen von Grenzwerten, einen Alarm ausgibt.

Zur Vermeidung unnötiger Wiederholungen sei hinsichtlich weiterer Ausgestaltungen auf obige Ausführungen bzw. die in den Ansprüchen dargelegten Ausführungsvarianten verwiesen.

Der Ordnung halber sei abschließend darauf hingewiesen, dass zum besseren Verständnis des Aufbaus der Vorrichtung 1 diese bzw. deren Bestandteile teilweise unmaßstäblich und/oder vergrößert und/oder verkleinert dargestellt wurden.

Die den eigenständigen erfinderischen Lösungen zugrunde liegende Aufgabe kann der Beschreibung entnommen werden.

Vor allem können die einzelnen in den Fig. 1 und 2 gezeigten Ausführungen den Gegenstand von eigenständigen, erfindungsgemäßen Lösungen bilden. Die diesbezüglichen erfindungsgemäßen Aufgaben und Lösungen sind den Detailbeschreibungen dieser Figuren zu entnehmen.

### Bezugszeichenaufstellung

- 1: Schichtaufbau
- 2: Flachseite der Trägerlage
- 3: Trägerlage
- 4: Erste Elektrode
- 5: Zweite Elektrode

- 6: Halbleitende Schicht
- 7: Untere Flachseite
- 8: Obere Flachseite
- 9: Dicke
- 10: Höhe

- 11: Obere Flachseite der Elektrode
- 12: Halbleitende Schichten
- 13: Dicke
- 14: Ladungsträger freisetzende Beeinflussung
- 15: Von oben einwirkende Beeinflussung

- 16: Von unten einwirkende Beeinflussung
- 17: Erste Fingerelektrode
- 18: Zweite Fingerelektrode
- 19: Abstand

## Patentansprüche

1. Schichtaufbau (1) mit halbleitenden Materialien auf einer Trägerlage (3) welcher zumindest eine flächenhafte, halbleitende Schicht (6) und mehrere, insbesondere eine erste (4) und zweite (5), Elektroden umfasst, wobei die halbleitende Schicht (6) eine obere (8) und untere (7) Flachseite aufweist, die im Wesentlichen parallel zueinander verlaufen und durch die Höhe der Schicht (10) voneinander distanziert sind und wo die halbleitende Schicht (6) mit der unteren Flachseite (7) auf einer Flachseite der Trägerlage (2) aufgebracht ist und wobei die zumindest zwei Elektroden an zwei gegenüber liegenden Stirnflächen der halbleitenden Schicht und/oder an dazu zumindest annähernd parallelen Ebenen zwischen den beiden Stirnflächen angeordnet sind und elektrisch leitend mit der halbleitenden Schicht verbunden sind **dadurch gekennzeichnet, dass** die zumindest zwei Elektroden auf die Trägerlage (3) aufgedruckt sind.

2. Schichtaufbau nach Anspruch 1, **dadurch gekennzeichnet, dass** die Trägerlage (3), die halbleitende Schicht (6) und die Elektroden flexibel und elastisch rückstellbar verformbar sind.

3. Schichtaufbau nach Anspruch 1 oder 2, **dadurch gekennzeichnet, dass** die Trägerlage (3) aus einem transparenten Material gebildet ist.

4. Schichtaufbau nach einem der vorhergehenden Ansprüche, **dadurch gekennzeichnet, dass** die Trägerlage (3) aus einem elektrisch nicht leitenden Material gebildet ist.

5. Schichtaufbau nach einem der vorhergehenden Ansprüche, **dadurch gekennzeichnet, dass** das halbleitende Material aus einer Gruppe umfassend photoaktive Materialien, organische und anorganische halbleitende Materialien gebildet ist.

6. Schichtaufbau nach Anspruch 5, **dadurch gekennzeichnet, dass** auf der halbleitenden Schicht (6), zumindest eine weitere, bevorzugt aus einem anderen halbleitenden Material gebildete, halbleitende Schicht (12) aufgebracht ist.

7. Schichtaufbau nach Anspruch 5 oder 6, **dadurch gekennzeichnet, dass** das photoaktive Material zur Absorption eines Teilbereichs des Spektrums des Sonnenlichts ausgebildet ist, beispielsweise im Bereich von 500nm bis 650nm.

8. Schichtaufbau nach Anspruch 7, **dadurch gekennzeichnet, dass** das photoaktive Material für den nicht absorbierten Teilbereich des Spektrums des Sonnenlichts transparent bzw. semi-transparent ist.

9. Schichtaufbau nach Anspruch 6 und 8, **dadurch gekennzeichnet, dass** jede aufgebrachte photoaktive Schicht einen anderen Teilbereich des Spektrums des Sonnenlichts absorbiert.

10. Schichtaufbau nach einem der vorherigen Ansprüche, **dadurch gekennzeichnet, dass** die Elektroden vollflächig an den Seitenflächen der halbleitenden Schicht (6) elektrisch leitend verbunden sind.

11. Schichtaufbau nach einem der vorherigen Ansprüche, **dadurch gekennzeichnet, dass** die erste (4) bzw. zweite (5) Elektrode aus jeweils einem unterschiedlichen Metall gebildet ist, beispielsweise die erste Elektrode aus Aluminium (Al) und die zweite Elektrode aus Kupfer (Cu) oder Gold (Au), wobei die Elektronenaustrittarbeit (work function) der beiden Metalle unterschiedlich ist.

12. Schichtaufbau nach Anspruch 11, **dadurch gekennzeichnet, dass** alle ersten (4) und zweiten (5) Elektroden elektrisch leitend miteinander verbunden sind.

13. Schichtaufbau nach einem der vorherigen Ansprüche, **dadurch gekennzeichnet, dass** die Elektroden als ineinander verschränkte Fingerelektroden ausgebildet sind.

14. Verfahren zum Herstellen eines Schichtaufbaus (1) mit halbleitenden Materialien auf einer Trägerlage (3), insbesondere nach einem der Ansprüche 1 bis 13, welcher zumindest eine flächenhafte, halbleitende Schicht (6) und mehrere, insbesondere eine erste (4) und zweite (5), Elektroden umfasst, wobei die halbleitende Schicht (6) eine obere (8) und untere (7) Flachseite aufweist, die im Wesentlichen parallel zueinander verlaufen und durch die Höhe der Schicht (10) voneinander distanziert sind und die halbleitende Schicht (6) mit der unteren Flachseite (7) auf einer Flachseite der Trägerlage (2) aufgebracht ist und wobei die beiden Elektroden an zwei gegenüber liegenden Stirnflächen der halbleitenden Schicht und/oder an dazu zumindest annähernd parallelen Ebenen zwischen den beiden Stirnflächen angeordnet sind und elektrisch leitend mit der halbleitenden Schicht verbunden sind **dadurch gekennzeichnet, dass** die zumindest zwei Elektroden auf die Trägerlage (3) aufgedruckt werden.

15. Verfahren zum Herstellen eines Schichtaufbaus (1) mit halbleitenden Materialien auf einer Trägerlage (3) nach Anspruch 14, **dadurch gekennzeichnet, dass** abwechselnd und voneinander distanziert, erste (4) und zweite (5) Elektroden aufgebracht werden.

16. Verfahren zum Herstellen eines Schichtaufbaus (1) mit halbleitenden Materialien auf einer Trägerlage (3) nach einem der Ansprüche 14 oder 15, **dadurch gekennzeichnet, dass** die Elektroden mittels eines Strukturierungsverfahren, beispielsweise Lithografie; Siebdruck, Ink-Jet, Nanoimprint, Stempeldruck, Laser Ablation auf die Trägerlage aufgebracht werden.

17. Verfahren zum Herstellen eines Schichtaufbaus (1) mit halbleitenden Materialien auf einer Trägerlage (3) nach einem der Ansprüche 14 bis 16, **dadurch gekennzeichnet, dass** die beiden Elektroden als verschränkte Fingerelektroden aufgebracht werden.

18. Verfahren zum Herstellen eines Schichtaufbaus (1) mit halbleitenden Materialien auf einer Trägerlage (3) nach einem der Ansprüche 14 bis 17, **dadurch gekennzeichnet, dass** die halbleitende Schicht (6) vollflächig aufgebracht wird.

19. Verfahren zum Herstellen eines Schichtaufbaus (1) mit halbleitenden Materialien auf einer Trägerlage (3) nach einem der Ansprüche 14 bis 18, **dadurch gekennzeichnet, dass** zum Auftragen der halbleitenden Schicht (6) ein Verfahren aus der Gruppe umfassend Bedampfung und Flächendruck, eingesetzt wird.

20. Verfahren zum Herstellen eines Schichtaufbaus (1) mit halbleitenden Materialien auf einer Trägerlage (3) nach einem der Ansprüche 14 bis 19, **dadurch gekennzeichnet, dass** die halbleitende Schicht (6) strukturiert aufgebracht wird.

21. Verfahren zum Herstellen eines Schichtaufbaus (1) mit halbleitenden Materialien auf einer Trägerlage (3) nach Anspruch 20, **dadurch gekennzeichnet, dass** zum strukturierten Auftragen ein Verfahren aus der Gruppe umfassend Tintenstrahl-Druck, Siebdruck, Laser Ablation eingesetzt wird.

22. Verfahren zum Herstellen eines Schichtaufbaus (1) mit halbleitenden Materialien auf einer Trägerlage (3) nach einem der Ansprüche 14 bis 21, **dadurch gekennzeichnet, dass** während des Aufbringens der halbleitenden Schicht (6) ein Elektrisches Feld von zumindest 10⁻⁵V/cm angelegt wird.

23. Verfahren zum Herstellen eines Schichtaufbaus (1) mit halbleitenden Materialien auf einer Trägerlage (3) nach einem der Ansprüche 14 bis 22, **dadurch gekennzeichnet, dass** durch geeignete Materialkombinatiönen, beispielsweise aus Polymeren, Carbon Nanotubes, Small Molecules, Dendrimers, Quantum Dots, anorgan. Nanopartikel, sowie Mischungen von diesen, eine höhere Quanteneffizienz der halbleitenden Schicht (6) erzielt wird.

24. Verfahren zum Herstellen eines Schichtaufbaus (1) mit halbleitenden Materialien auf einer Trägerlage (3) nach einem der Ansprüche 14 bis 23, **dadurch gekennzeichnet, dass** auf der oberen Flachseite (8) der halbleitende Schicht (6) zumindest eine weitere, bevorzugt aus einem anderen halbleitenden Materialgebildete, Schicht (12) aufgebracht wird.

25. Solarzelle zur Freisetzung von Ladungsträger durch das Einwirken einer elektromagnetischen Welle, insbesondere Licht, **dadurch gekennzeichnet, dass** die Solarzelle einen Schichtaufbau gemäß einem der Ansprüche 1 bis 13 aufweist.

26. Transistor, **dadurch gekennzeichnet, dass** der Transistor einen Schichtaufbau gemäß einem der Ansprüche 1 bis 13 aufweist.

## Claims

1. A layered structure (1) with semiconducting materials on a support layer (3) comprising at least one planar semiconducting layer (6) and several electrodes, in particular a first (4) and second (5) one, wherein the semiconducting layer (6) has a top (8) and bottom (7) flat face which extend essentially parallel to another and are spaced apart from one another by the height of the layer (10), and the semiconducting layer (6) is applied with the bottom flat face (7) on a flat face of the support layer (2), the at least two electrodes being disposed on two oppositely lying end faces of the semiconducting layer and/or in planes at least approximately parallel thereto between the two end faces and being connected to the semiconducting layer in an electrically conducting manner, **characterised in that** the at least two electrodes are printed onto the support layer (3).

2. The layered structure as claimed in claim 1, **characterised in that** the support layer (3), the semiconducting layer (6) and the electrodes are flexible and elastically deformable and reboundable.

3. The layered structure as claimed in claim 1 or 2, **characterised in that** the support layer (3) is made from a transparent material.

4. The layered structure as claimed in one of the preceding claims, **characterised in that** the support layer (3) is made from an electrically non-conducting material.

5. The layered structure as claimed in one of the preceding claims, **characterised in that** the semiconducting material is selected from a group comprising photoactive materials, organic and inorganic semiconducting materials.

6. The layered structure as claimed in claim 5, **characterised in that** at least one other semiconducting layer (12), preferably made from a different semiconducting material, is applied on the semiconducting layer (6).

7. The layered structure as claimed in claim 5 or 6, **characterised in that** the photoactive material is designed to absorb a part-range of the spectrum of sunlight, for example in the range of 500 nm to 650 nm.

8. The layered structure as claimed in claim 7, **characterised in that** the photoactive material is transparent or semi-transparent for the non-absorbed part-range of the spectrum of sunlight.

9. The layered structure as claimed in claims 6 and 8, **characterised in that** every photoactive layer applied absorbs a different part-range of the spectrum of sunlight.

10. The layered structure as claimed in one of the preceding claims, **characterised in that** the electrodes are connected in an electrically conducting manner to the full surface of the side faces of the semiconducting layer (6).

11. The layered structure as claimed in one of the preceding claims, **characterised in that** the first (4) and second (5) electrodes, respectively, are each made from a different metal, for example, the first electrode is made from aluminium (Al) and the second electrode is made from copper (Cu) or gold (Au), and the electron work function of the two metals is different.

12. The layered structure according to claim 11, **characterised in that** all of the first (4) and second (5) electrodes are connected to one another in an electrically conducting manner.

13. The layered structure as claimed in one of the preceding claims, **characterised in that** the electrodes are provided in the form of mutually interlocking finger electrodes.

14. A method of producing a layered structure (1) with semiconducting materials on a support layer (3), in particular as claimed in one of claims 1 to 13, which layered structure comprises at least one planar semiconducting layer (6) and several electrodes, in particular a first (4) and second (5) one, wherein the semiconducting layer (6) has a top (8) and bottom (7) flat face extending essentially parallel to one another and spaced apart from one another by the height of the layer (10), and the semiconducting layer (6) is applied with the bottom flat face (7) on a flat face of the support layer (2), the at least two electrodes being disposed on two oppositely lying end faces of the semiconducting layer and/or in planes at least approximately parallel thereto between the two end faces and being connected to the semiconducting layer in an electrically conducting manner, **characterised in that** the at least two electrodes are printed onto the support layer (3).

15. The method of producing a layered structure (1) with semiconducting materials on a support layer (3) as claimed in claim 14, **characterised in that** first (4) and second (5) electrodes are disposed in an alternating arrangement and spaced apart from one another.

16. The method of producing a layered structure (1) with semiconducting materials on a support layer (3) as claimed in claim 14 or 15, **characterised in that** the electrodes are applied onto the support layer by means of a structuring method, for example, lithography, screen printing, inkjet printing, nanoimprinting, stamp printing, laser ablation.

17. The method of producing a layered structure (1) with semiconducting materials on a support layer (3) as claimed in one of claims 14 to 16, **characterised in that** the two electrodes are applied in the form of interlocking finger electrodes.

18. The method of producing a layered structure (1) with semiconducting materials on a support layer (3) as claimed in one of claims 14 to 17, **characterised in that** the semiconducting layer (6) is applied on the entire surface.

19. The method of producing a layered structure (1) with semiconducting materials on a support layer (3) as claimed in one of claims 14 to 18, **characterised in that** a method from the group comprising vapour deposition and surface printing is used for applying the semiconducting layer (6).

20. The method of producing a layered structure (1) with semiconducting materials on a support layer (3) as claimed in one of claims 14 to 19, **characterised in that** the semiconducting layer (6) is applied in a structured manner.

21. The method of producing a layered structure (1) with semiconducting materials on a support layer (3) as claimed in claim 20, **characterised in that** a method from the group comprising inkjet printing, screen printing, laser ablation is used for applying a structured arrangement.

22. The method of producing a layered structure (1) with semiconducting materials on a support layer (3) as claimed in one of claims 14 to 21, **characterised in that** an electric field of at least 10⁻⁵ V/cm is applied whilst the semiconducting layer (6) is being applied.

23. The method of producing a layered structure (1) with semiconducting materials on a support layer (3) as claimed in one of claims 14 to 22, **characterised in that** a higher quantum efficiency of the semiconducting layer (6) is obtained by using suitable material combinations, for example of polymers, carbon nano-tubes, small molecules, dendrimers, quantum dots, inorganic nano-particles and mixtures thereof.

24. The method of producing a layered structure (1) with semiconducting materials on a support layer (3) as claimed in one of claims 14 to 23, **characterised in that** at least one further layer (12), preferably made from a different semiconducting material, is applied on the top flat face (8) of the semiconducting layer (6).

25. A solar cell for releasing charge carriers due to the effect of an electromagnetic wave, in particular light, **characterised in that** the solar cell has a layered structure as claimed in one of claims 1 to 13.

26. A transistor, characterised that the transistor has a layered structure as claimed in one of claims 1 to 13.

## Revendications

1. Structure en couches (1) avec des matériaux semi-conducteurs sur une couche de support (3), qui comprend au moins une couche semi-conductrice en surface (6) et plusieurs, plus particulièrement une première(4) et une deuxième (5), électrodes, la couche semi-conductrice (6) comprenant des faces plates supérieure (8) et inférieure (7), qui s'étendent globalement parallèlement entre elles et sont distantes entre elles de la hauteur de la couche (10) et la couche semi-conductrice (6) étant appliquée avec la face plate inférieure (7) sur une face plate de la couche de support (2) et les au moins deux électrodes étant disposées sur deux faces frontales superposées de la couche semi-conductrice et/ou sur deux plans au moins approximativement parallèles à celle-ci entre les deux faces frontales, et étant reliées électriquement avec la couche semi-conductrice, **caractérisée en ce que** les au moins deux électrodes sont imprimées sur la couche de support (3).

2. Structure en couches selon la revendication 1, **caractérisée en ce que** la couche de support (3), la couche semi-conductrice (6) et les électrodes sont déformables de manière flexible et de façon à reprendre leur forme de manière élastique.

3. Structure en couches selon la revendication 1 ou 2, **caractérisée en ce que** la couche de support (3) est constituée d'un matériau transparent.

4. Structure en couches selon l'une des revendications précédentes, **caractérisée en ce que** la couche de support (3) est constituée d'un matériau non conducteur.

5. Structure en couches selon l'une des revendications précédentes, **caractérisée en ce que** le matériau semi-conducteur est constitué d'un groupe comprenant des matériaux photo-actifs, des matériaux organiques et inorganiques.

6. Structure en couches selon la revendication 5, **caractérisée en ce que**, sur la couche semi-conductrice (6), est appliquée au moins une couche semi-conductrice (12) supplémentaire constituée, de préférence, d'un autre matériau semi-conducteur.

7. Structure en couches selon la revendication 5 ou 6, **caractérisée en ce que** le matériau photo-actif est conçu pour l'absorption d'une partie du spectre de la lumière du soleil, par exemple de l'ordre de 500 nm à 650 nm.

8. Structure en couches selon la revendication 7, **caractérisée en ce que** le matériau photo-actif est transparent ou semi-transparent pour la partie non absorbée du spectre de la lumière du soleil.

9. Structure en couches selon la revendication 6 ou 8, **caractérisée en ce que** chaque couche photo-active appliquée absorbe une partie différente du spectre de la lumière du soleil.

10. Structure en couches selon l'une des revendications précédentes, **caractérisée en ce que** les électrodes sont reliées électriquement sur toute leur surface aux faces latérales de la couche semi-conductrice (6).

11. Structure en couches selon l'une des revendications précédentes, **caractérisée en ce que** la première (4) ou la deuxième (5) électrode est constituée d'un matériau différent, par exemple la première électrode est constituée d'aluminium (Al) et la deuxième électrode est constituée de cuivre (Cu) ou d'or (Au), le travail de sortie des électrons (work function) des deux métaux étant différent.

12. Structure en couches selon la revendication 11, **caractérisée en ce que** toutes les premières (4) et deuxième (5) électrodes sont reliées électriquement entre elles.

13. Structure en couches selon l'une des revendications précédentes, **caractérisée en ce que** les électrodes sont conçues comme des électrodes en forme de doigts imbriquées les unes dans les autres.

14. Procédé de fabrication d'une structure en couches (1) avec un matériau semi-conducteur sur une couche de support (3), plus particulièrement selon l'une des revendications 1 à 13, qui comprend au moins une couche semi-conductrice en surface (6) et plusieurs, plus particulièrement une première (4) et une deuxième (5), électrodes, la couche semi-conductrice (6) comprenant des faces plates supérieure (8) et inférieure (7), qui s'étendent globalement parallèlement entre elles et sont distantes entre elles de la hauteur de la couche (10) et la couche semi-conductrice (6) étant appliquée avec la face plate inférieure (7) sur une face plate de la couche de support (2) et les deux électrodes étant disposées sur deux faces frontales superposées de la couche semi-conductrice et/ou sur deux plans au moins approximativement parallèles à celle-ci entre les deux faces frontales, et étant reliées électriquement avec la couche semi-conductrice, **caractérisée en ce que** les au moins deux électrodes sont imprimées sur la couche de support (3).

15. Procédé de fabrication d'une structure en couches (1) avec un matériau semi-conducteur sur une couche de support (3) selon la revendication 14, **caractérisé en ce qu'**une première (4) et une deuxième (5) électrodes sont appliquées de manière alternée et distantes entre elles.

16. Procédé de fabrication d'une structure en couches (1) avec un matériau semi-conducteur sur une couche de support (3) selon l'une des revendications 14 ou 15, **caractérisé en ce que** les électrodes sont appliquées au moyen d'un procédé de structuration, par exemple de lithographie, de sérigraphie, de jet d'encre, de Nanoimprint, d'impression au tampon, d'ablation laser.

17. Procédé de fabrication d'une structure en couches (1) avec un matériau semi-conducteur sur une couche de support (3) selon l'une des revendications 14 à 16, **caractérisé en ce que** les deux électrodes sont appliquées comme des électrodes en forme de doigts imbriquées.

18. Procédé de fabrication d'une structure en couches (1) avec un matériau semi-conducteur sur une couche de support (3) selon l'une des revendications 14 à 17, **caractérisé en ce que** la couche semi-conductrice (6) est appliquée sur toute la surface.

19. Procédé de fabrication d'une structure en couches (1) avec un matériau semi-conducteur sur une couche de support (3) selon l'une des revendications 14 à 18, **caractérisé en ce que**, pour l'application de la couche semi-conductrice (6), un procédé du groupe comprenant une vaporisation et une pression de surface est utilisé.

20. Procédé de fabrication d'une structure en couches (1) avec un matériau semi-conducteur sur une couche de support (3) selon l'une des revendications 14 à 19, **caractérisé en ce que** la couche semi-conductrice (6) est appliquée de manière structurée.

21. Procédé de fabrication d'une structure en couches (1) avec un matériau semi-conducteur sur une couche de support (3) selon la revendication 20, **caractérisé en ce que**, pour l'application structurée, un procédé du groupe comprenant une impression à jet d'encre, une sérigraphie, une ablation laser, est utilisé.

22. Procédé de fabrication d'une structure en couches (1) avec un matériau semi-conducteur sur une couche de support (3) selon l'une des revendications 14 à 21, **caractérisé en ce que**, pendant l'application de la couche semi-conductrice (6), un champ électrique d'au moins 10⁻⁵ V/cm est appliqué.

23. Procédé de fabrication d'une structure en couches (1) avec un matériau semi-conducteur sur une couche de support (3) selon l'une des revendications 14 à 22, **caractérisé en ce que** des combinaisons appropriées de matériaux, par exemple des polymères, des nanotubes de carbone, des petites molécules, des dendrimères, des quantum dots, des nanoparticules inorganiques ainsi que des mélanges de ceux-ci permettent d'obtenir une efficacité quantique plus élevée de la couche semi-conductrice (6).

24. Procédé de fabrication d'une structure en couches (1) avec un matériau semi-conducteur sur une couche de support (3) selon l'une des revendications 14 à 23, **caractérisé en ce que**, sur la face plate (8) de la couche semi-conductrice (6) est appliquée au moins une autre couche (12) constituée de préférence d'un autre matériau semi-conducteur.

25. Cellule photovoltaïque pour la libération de porteurs de charges sous l'effet d'une onde électromagnétique, plus particulièrement de la lumière, **caractérisée en ce que** la cellule photovoltaïque comprend une structure en couches selon l'une des revendications 1 à 13.

26. Transistor **caractérisé en ce que** le transistor comprend une structure en couches selon l'une des revendications 1 à 13.
